# EUROPEAN PATENT APPLICATION

(11) **EP 4 712 064 A1**
(43) Date of publication of application: **18.03.2026**
(21) Application number: 25152986.3
(22) Date of filing: 21.01.2025
(51) Int. Cl.: G09F 9/33, G09F 9/302

(54) **LED TRANSPARENT DISPLAY**

(30) Priority: 14.09.2024 CN 202422263408 U
(71) Applicant: Roe Visual Co Ltd, Shenzhen City, Guangdong 518000 (CN)
(72) Inventor: DENG, Shengyun, Shenzhen City (CN); ZHONG, Hua, Shenzhen City (CN); DAI, Lisheng, Shenzhen City (CN); TIAN, Zhichun, Shenzhen City (CN); CHEN, Lei, Shenzhen City (CN)
(74) Representative: Renaudo, Adrien Hanouar

(57) **Abstract**

The embodiment of the present disclosure provides an LED transparent display including a PCB board, a plurality of connection pieces, and a plurality of LED beads, the plurality of LED beads are arranged in an array on the PCB board, which is provided with a plurality of first through-holes. The plurality of LED beads are distributed around the plurality of first through-holes. The plurality of connection pieces are provided on one side of the PCB board opposite to the plurality of LED beads, and each connection piece has a plurality of connecting posts on a side toward the PCB board. The plurality of connecting posts pass through the plurality of first through-holes and are provided with adhesive applied at ends thereof. In the LED transparent display according to embodiments of the present disclosure, the adhesive at the ends of the connecting posts allows the transparent display to be fixed to transparent glass, so as to facilitate disassembly and maintenance of the transparent display and prevent display quality from being degraded due to adhesive applied directly to the LED beads.

## Description

### CROSS-REFERENCE TO RELATED APPLICATION

This application claims priority to Chinese Patent Application No. 202422263408.X, which is hereby incorporated by reference in its entirety.

### TECHNICAL FIELD

The present disclosure relates to the field of electronic display apparatus, and particularly to an LED transparent display.

### BACKGROUND

Nowadays, LED transparent display is widely used. Sometimes, display may be mounted onto transparent glass for higher strength and better texture. Currently, the display is mounted onto transparent glass generally by applying adhesive on a surface of LED beads and then bonding the beads to the transparent glass via adhesive. However, such structure has disadvantages: it is difficult to disassemble for repair, and the display quality may be degraded due to adhesive applied directly to the LED beads.

### SUMMARY

In view of the above issues, in the embodiments of the present disclosure, an LED transparent display is proposed to address or at least partially address these problems.

Embodiments of the present disclosure provide an LED transparent display including a PCB board, a plurality of connection pieces, and a plurality of LED beads, the plurality of LED beads are arranged in an array on the PCB board, which is provided with a plurality of first through-holes. The plurality of LED beads are distributed around the plurality of first through-holes. The plurality of connection pieces are provided on one side of the PCB board opposite to the plurality of LED beads, and each connection piece has a plurality of connecting posts on a side toward the PCB board. The plurality of connecting posts pass through the plurality of first through-holes and are provided with adhesive applied at ends thereof.

Furthermore, the connection pieces are provided with second through-holes corresponding to the plurality of first through-holes.

Furthermore, a height of the connecting posts from the PCB board is not less than the height of the LED beads from the PCB board.

Furthermore, the connecting posts and the connection pieces are integrally formed.

Furthermore, the LED transparent display further includes:
a reinforcement plate provided between the PCB board and the connection pieces, the ends of the plurality of connecting posts pass through the reinforcement plate.

Furthermore, the reinforcement plate is provided with third through-holes corresponding to the plurality of first through-holes thereon, and the ends of the plurality of connecting posts sequentially pass through the third through-holes and the first through-holes.

Furthermore, the reinforcement plate is made of carbon fiber.

Furthermore, the plurality of connecting posts on one connection piece are distributed on both sides of a joint between two PCB boards.

Furthermore, four connection pieces are provided at four corners on a side of the PCB board opposite to the plurality of LED beads.

Furthermore, the plurality of connection pieces are provided on a side of the PCB board opposite to the LED beads with regular spacing.

Furthermore, a radius of the second through-hole is greater than or equal to a radius of the first through-hole.

Furthermore, a diameter of the connecting post is smaller than a diameter of the first through-hole.

Furthermore, a difference between a radius of the first through-hole and a radius of the connecting post is greater than or equal to 0.2 mm and smaller than or equal to 0.3 mm.

Furthermore, a guiding surface is provided at circumference of the end of the connecting post opposite to the PCB board.

Furthermore, the connection piece is provided with at least one connecting post thereon;
at least one first through-hole is provided between two adjacent connecting posts.

Furthermore, at least the connecting posts and portions of the connection pieces aligned with the connecting posts on the connection pieces are made of transparent material.

Furthermore, side surfaces of the connecting posts are frosted.

Furthermore, a combined support strength of the plurality of connection pieces is at least eight times a weight of the LED transparent display.

In the technical solution provided by the embodiments of the present disclosure, an LED transparent display includes a PCB board, a plurality of connection pieces, and a plurality of LED beads. The PCB board is provided with a plurality of first through-holes, and the plurality of LED beads are arranged in an array on the PCB board and distributed around the plurality of first through-holes, so that a transparent display is formed. The plurality of connection pieces are provided on a side of the PCB board opposite to the plurality of LED beads, and each connection piece has a plurality of connecting posts on a side toward the PCB board. The plurality of connecting posts pass through the plurality of first through-holes and are provided with adhesive applied at ends thereof. The adhesive at the ends of the connecting posts allows the transparent display to be fixed to transparent glass, so as to facilitate disassembly and maintenance of the transparent display and prevent display quality from being degraded due to adhesive applied directly to the LED beads.

### BRIEF DESCRIPTION OF THE DRAWINGS

To better illustrate the technical solutions of the embodiments of the present disclosure or prior art, a brief introduction will be made on the drawings required in describing the embodiments or prior art. It is obvious that the drawings described below are some embodiments of the present disclosure. For those skilled in the art, other drawings are obtainable based on these drawings without creative efforts.
FIG. 1 is a schematic view of a planar connection of an LED transparent display provided by an embodiment of the present disclosure.
FIG. 2 is a cross-sectional structural schematic view of an LED transparent display provided by an embodiment of the present disclosure.
FIG. 3 is a schematic view of another planar connection of an LED transparent display provided by an embodiment of the present disclosure.
FIG. 4 is another cross-sectional structural schematic view of an LED transparent display provided by an embodiment of the present disclosure.
FIG. 5 is a planar structural schematic view of the LED transparent display provided by an embodiment of the present disclosure in which two screens are connected with each other.

### DETAILED DESCRIPTION

In order to better clarify the object, technical solutions, and advantages of embodiments of the present disclosure, the technical solutions in the embodiments of the present disclosure will be clearly and completely described below in conjunction with the drawings in the embodiments of the present disclosure. It is obvious that the embodiments as described below are merely a part of the embodiments of the present disclosure, not all of them. Based on the embodiments of the present disclosure, all other embodiments obtainable by those skilled in the art without creative effort should fall within the scope of the present disclosure.

It should be noted that in the description of the present invention, if terms such as "first" and "second" are used, these terms are used merely for the convenience of distinguishing different components or names and should not be interpreted as indicating or implying sequential relationships, relative importance, or the quantity of the related technical features. Therefore, features defined with "first" and "second" may explicitly or implicitly include at least one of such features. Additionally, if "and/or" is used in the description, it means that there are three possible technical solutions, i.e., taking "A and/or B" as an example, it includes the solutions of only A, only B, or both A and B.

Unless otherwise defined, all technical and scientific terms used herein have the same meaning as commonly understood by those skilled in the art to which the present disclosure pertains. The terms used in the description of the present invention is intended only to describe specific embodiments and is not intended to limit the present disclosure.

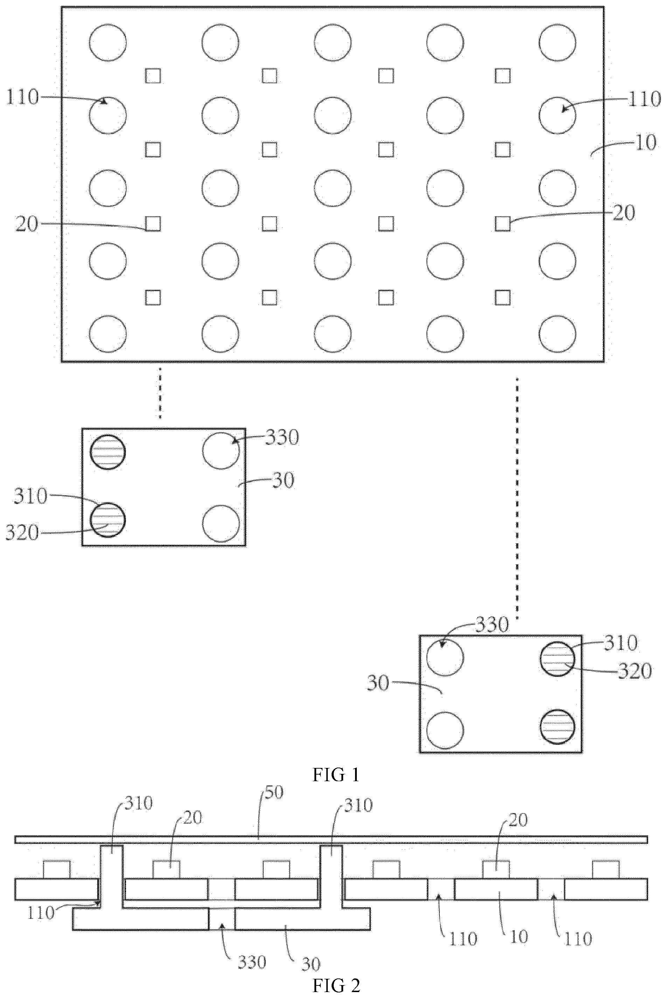

Referring to FIG. 1, which shows a schematic view of a planar connection of a light-emitting diode (LED) transparent display, referred as LED transparent display hereafter, provided by an embodiment of the present disclosure, the LED transparent display includes a printed circuit board (PCB) 10, a plurality of LED beads 20, and a plurality of connection pieces 30.

The plurality of LED beads 20 may be coupled to the PCB 10. The PCB 10 may transmit information and supply power to the LED beads 20. Upon receiving instructions transmitted from the PCB 10, the LED beads 20 may emit specific light at specific time as required in the instructions, so that the LED transparent display may display various images or videos.

In some embodiments of the present disclosure, a controller capable of executing instructions may be integrated into the LED beads 20, and the PCB 10 may be only used to transmit instruction information and power. Therefore, it may be unnecessary for additional electronic components to be provided on the PCB 10 to process information and issue instructions, so that surface of the PCB 10 may be neater to ensure that there are no protrusions on the side of the PCB 10 on which the LED beads 20 are provided and the side may have a more aesthetically pleasing appearance and ensure that the side of the PCB 10 opposite the LED beads 20 may be have a certain flatness to facilitate mounting of the PCB 10.

Typically, the side of the PCB 10 on which the LED beads 20 are provided is black, as coloring in black may render protrusions on the PCB 10 covered, so that the LED transparent display may be more aesthetically pleasing when the display is not working and improves the viewing experience. Certainly, the color for coloring the PCB 10 may be customized as required by customers and is not limited to black. However, it is preferable that the PCB 10 is colored in a uniform color to ensure aesthetically pleasing appearance without degrading the viewing experience.

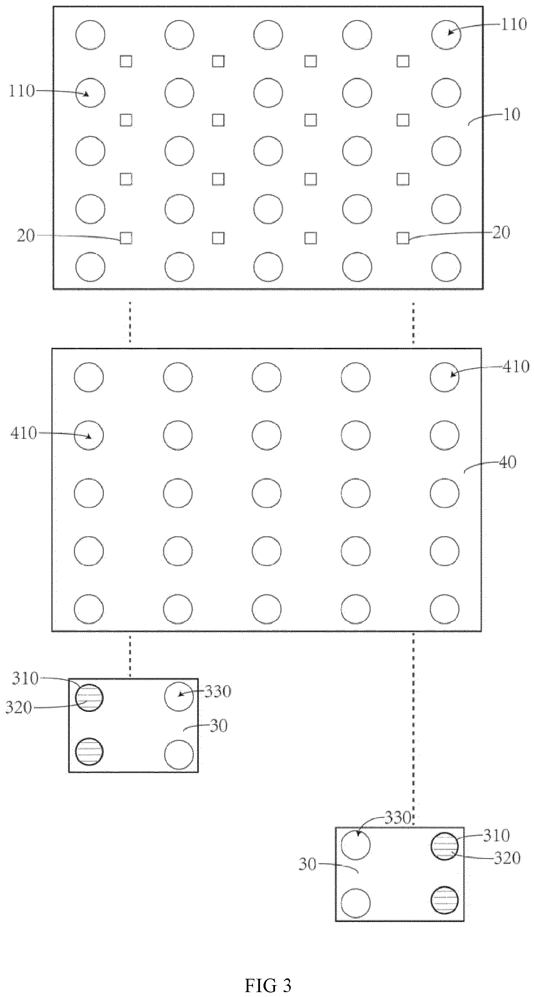

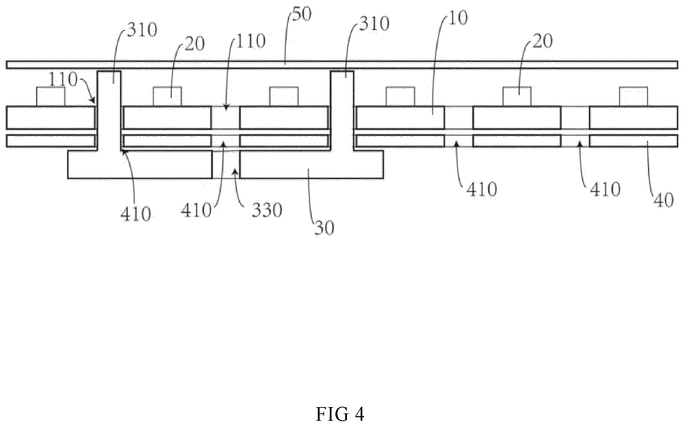

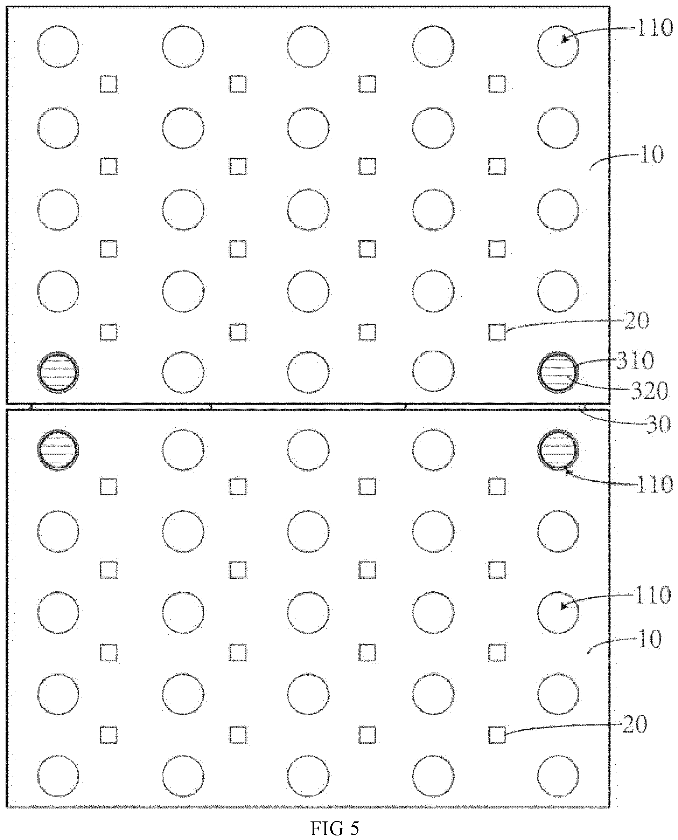

Referring to FIGS. 2-5, the plurality of LED beads 20 are arranged in an array on the PCB 10. The PCB 10 may be provided with a plurality of first through-holes 110. The plurality of LED beads 20 may be distributed around the plurality of first through-holes 110. The plurality of connection pieces 30 may be provided on the side of the PCB 10 opposite to the plurality of LED beads 20. Each connection piece 30 has a plurality of connecting posts 310 on a side toward the PCB 10. The plurality of connecting posts 310 may pass through the first through-holes 110 and have adhesive 320 applied to the end thereof.

Transparent glass may abut with the ends of the connecting posts 310 and may be adhered to the supporting ends by using the adhesive 320, so that it is unnecessary to apply adhesive to the LED beads. The LED beads may be spaced from the supporting part or contact with the supporting part without any connecting medium therebetween to affect the disassembly and maintenance of the LED beads.

Specifically, the PCB 10 may be provided with the plurality of first through-holes 110, whose sizes may be determined based on dimensions and thickness of the PCB 10 and specific specifications of the display. The plurality of first through-holes 110 may be arranged in an array on the PCB 10. The plurality of LED beads 20 may be provided in the gaps between the first through-holes 110, so that the plurality of LED breads may be provided in an array on the PCB 10. Generally, the plurality of first through-holes 110 may be provided around each LED bead 20. With such arrangement of the plurality of first through-holes 110 on the PCB 10 provided with the plurality of first through-holes 110, an LED display may be turned into an LED transparent display, allowing visibility from one side of the display to the other.

The LED beads 20 are provided at a center of the array of first through-holes 110. Each LED bead 20 is surrounded by four first through-holes 110 evenly spaced from one another. Two adjacent first through-holes 110 may form an angle of 90° therebetween with the LED bead 20 as a center of a circle. Similarly, each first through-hole 110 is surrounded by four LED beads 20 evenly spaced from one another. Two adjacent LED beads 20 may form an angle of 90° therebetween with the first through-hole 110 as a center of a circle. The space between any two adjacent first through-holes 110 may only allow one LED bead 20 to be mounted therein, so that a maximum transparency may be achieved without any negative effect on the mounting of the LED beads 20.

The plurality of connection pieces 30 may be provided on the side of the PCB 10 opposite to the plurality of LED beads 20. That is to say, the connection pieces 30 and the LED beads 20 are located on opposite sides of the PCB 10. The connection pieces 30 are provided with the plurality of connecting posts 310 extending toward the PCB 10. The distribution of the plurality of connecting posts 310 generally corresponds to the plurality of first through-holes 110 on the PCB 10 in one-to-one relationship. The diameter of the connecting posts 310 is slightly smaller than the inner diameter of the first through-holes 110, so that the plurality of connecting posts 310 may pass through the plurality of first through-holes 110, and the ends of the connecting posts 310 may extend beyond the side of the PCB 10 with the LED beads 20 provided thereon, and protrude above a surface of the LED beads 20. Adhesive 320 may be applied on the ends of the connecting posts 310. The adhesive 320 may have high adhesive, so that the LED transparent display may be fixed to transparent glass by the adhesive 320 on the ends of the connecting posts 310 of the connection pieces, which pass through the first through-holes 110, when the LEDC transparent display is required to be fixed onto the transparent glass. Such way of fixing the LED transparent display on the transparent glass by the adhesive 320 on the ends of the connecting posts 310 may facilitate disassembly and maintenance of the transparent display and prevent display quality from being degraded due to adhesive applied directly to the LED beads.

A distance between the connecting posts 310 and walls of the first through-holes 110 may be in a range of 0.2 mm to 0.3 mm, as long as the connecting posts 310 may be inserted into the first through-holes 110. It is understood that the larger the diameters of the connecting posts 310 are, the higher the support strength is. Therefore, the diameter of the connecting posts 310 should be as large as possible as long as the passage through the first through-holes 110 is ensured.

In some embodiments of the present disclosure, referring to FIGS. 2-5, the supporting end may be provided with a guiding surface on the circumferential surface thereof. The guiding surface may be inclined toward the supporting end from the circumferential surface of the end of the connecting post 310 opposite to the connecting body. It may be easier for the connecting posts 310 to enter the first through-holes 110 under the guidance of the guiding surface.

Furthermore, in other preferred embodiments of the present disclosure, the connection pieces 30 are provided with second through-holes 330 corresponding to the plurality of first through-holes 110.

The second through-hole 330 is coaxial with the first through-hole 110 and has a diameter equal to or greater than that of the first through-hole 110 so that the first through-hole 110 would not be blocked. Both the second through-hole 330 and the connecting post 310 correspond to the first through-hole 110. Specifically, some of the first through-holes 110 are coaxial with the connecting posts 310, while others are coaxial with the second through-holes 330, so as to ensure an optimal transparent effect of the LED transparent display.

It is understood that if the connecting posts 310 are not made of transparent material, the first through-holes 110 with the connecting posts 310 inserted may be unable to transmit light due to the blocking by the connecting posts 310, and the transparency of the LED transparent display may be degraded. Therefore, in some embodiments of the present disclosure, as shown in FIGS. 2-5, at least the connecting posts and the portions of the connection pieces aligned with the connecting posts are made of transparent material to facilitate light transmission. In other words, the connection piece 30 may be transparent at the connection part with the connecting posts 310, while the rest may remain opaque. Alternatively, the connection piece and the connecting posts 310 may be made entirely of the same transparent material, so that the entire connection piece may be transparent. There is no limitation on this in the present disclosure, as long as light transmission is not degraded. The transparent material may be polycarbonate (PC) or acrylic plastic, both of which has excellent transparency.

Furthermore, in other preferred embodiments of the present disclosure, a height of the connecting posts 310 from the PCB board 10 may be no less than a height of the LED beads 20 from the PCB board 10.

Specifically, on the side of the PCB board 10 opposite to the connection piece 30, the height of the connecting posts 310 may be no less than the height of the LED beads 20, so that when the LED transparent display is fixed to the transparent glass, there may be a gap ensured between the LED beads 20 and the transparent glass, or the LED beads 20 just make contact with the transparent glass, so as to protect the LED beads 20 and facilitate the disassembly and maintenance of the light panel of the LED when it is broken.

Furthermore, in other preferred embodiments of the present disclosure, as shown in FIGS. 2-5, the connecting posts 310 and the connection piece may be formed into an integrated structure. In other words, the connection piece forms as a whole.

Herein, the connecting posts 310 and the connection plate may be formed by using integrated injection molding, so that the connection piece 30 may have a high strength, and the reliability for fixing the LED transparent display onto the transparent glass via the connection piece 30 may be improved.

In this way, when the LED transparent display is fixed to the transparent glass, there is a gap ensured between the LED beads 20 and the transparent glass, or the LED beads 20 just make contact with the transparent glass, so as to protect the LED beads 20 and facilitate the disassembly and maintenance of the light panel of the LED when it is broken.

It is understood that a plurality of LED beads are provided around the periphery of the connecting posts 310. Light emitted by the LED beads will inevitably undergo refraction and reflection when entering the connecting posts 310 made of the transparent material, so that the transparency and display effect around the connecting posts 310 may be affected.

To address this issue, in some embodiments of this disclosure, as shown in FIGS. 2-5, the peripheral surface of the connecting posts 310 is frosted. The light emitted by the LED beads 20 may have a lower refraction index when the light encounters an anti-refraction structure, so that the display effect of the LED transparent display is not compromised, nor is its transparency. When light hit on the frosted surface of the connecting posts 310, it may be reflected outward as much as possible, rather than refracted into the connecting posts 310.

Furthermore, in other preferred embodiments of the present disclosure, as shown in FIGS. 2-5, the LED transparent display may further include:
a reinforcement plate 40, provided between the PCB board 10 and the connection piece 30, ends of a plurality of connecting posts 310 pass through the reinforcement plate 40.

Specifically, the reinforcement plate 40 may be mounted on a back side of the PCB board 10, i.e., between the PCB board 10 and the connection piece 30. The reinforcement plate 40 may improve the strength of the PCB board 10, so as to increase the overall strength of the LED transparent display.

Furthermore, in other preferred embodiments of the present disclosure, the reinforcement plate 40 may be provided with third through-holes 410 corresponding to the plurality of first through-holes 110. The ends of the plurality of connecting posts 310 sequentially pass through the third through-holes 410 and the first through-holes 110.

To ensure the overall transparency of the LED transparent display, it is necessary to provide corresponding third through-holes 410 in the reinforcement plate 40. Specifically, the plurality of third through-holes 410 may be provided on the reinforcement plate 40, and the plurality of third through-holes 410 may correspond to the plurality of first through-holes 110 in a one-to-one relationship. In preferred embodiments, their sizes of the plurality of third through-holes 410 and the sizes of the plurality of first through-holes 110 are same. The ends of the plurality of connecting posts 310 may sequentially pass through the third through-holes 410 and the first through-holes 110, extending above the PCB board 10 to be bonded with the transparent glass. Furthermore, in preferred embodiments of the present disclosure, the reinforcement plate 40 is made of carbon fiber.

Herein, the carbon fiber plate offers advantages such as lightweight and high strength. By using the carbon fiber plate as the reinforcement plate 40, the thickness of the reinforcement plate 40 may be minimized with strength as required, and the LED transparent display may be lighter to facilitate its mounting and fixing.

Furthermore, in other preferred embodiments of the present disclosure, the plurality of connecting posts 310 on one connection piece 30 may be distributed on both sides of the joint between two PCB boards 10. Herein, the connection piece 30 may not only bond the PCB board 10 to the transparent glass but also connect a plurality of PCB boards 10 together. Specifically, the connection piece 30 may be provided at the joint of two PCB boards 10, while a plurality of connecting posts 310 on the connection piece 30 may be distributed on both sides of the joint between the two PCB boards 10. When the plurality of connecting posts 310 are inserted into the first through-holes 110 of two PCB boards 10, the two PCB boards 10 may be easily connected together.

That is to say, at least one connection piece 30 may be provided between two adjacent PCB boards, and at least one connecting post 310 on the connection piece 30 is located on the other PCB board. At this time, the connection piece 30 is configured to connect the two adjacent PCB boards together. Some of the plurality of connecting posts 310 on the connection piece 30 are inserted in the first through-holes 110 of one PCB board and others are inserted in the first through-holes 110 of the other PCB board. The numbers of connecting posts 310 on the adjacent PCB boards are same. To ensure balanced connectivity, half of the connecting posts 310 on the same connection piece 30 are located on one PCB board 10, while the other half are located on the other PCB board 10.

Furthermore, in other preferred embodiments of the present disclosure, four connection pieces 30 are provided at four corners of the side of the PCB board 10 opposite to the side with the plurality of LED beads 20 provided thereon.

Specifically, the LED transparent display generally has a quadrilateral structure, and the PCB board 10 also has a quadrilateral structure. To ensure the strength of the bonding between the LED transparent display and the transparent glass, the connection pieces 30 are typically provided at the four corners of the side of the PCB board 10 opposite to the plurality of LED beads 20, so that the adhesive bonding between the PCB board 10 and the transparent glass may be balanced better.

Furthermore, in other preferred embodiments of the present disclosure, a plurality of connection pieces 30 are provided on the side of the PCB board 10 opposite to the plurality of LED beads 20 with regular spacing.

Specifically, when the PCB board 10 has a relatively large area, a plurality of connection pieces 30 may be provided on the side of the PCB board 10 opposite to the plurality of LED beads 20 to ensure relatively uniform adhesive bonding between the LED transparent display and the transparent glass. These connection pieces 30 are distributed with regular spacing.

Herein, the specific number of the plurality of connection pieces 30 is generally determined by the area of the PCB board 10 and the dimensions of each connection piece 30.

The number of connecting posts 310 on the connection piece 30 may be more than one. If there is only one connecting post 310 on the connection piece 30, it may be possible to save material and the support for the transparent glass may be more flexible. A distance between two adjacent connecting posts 310 may be equal or unequal, and additional connection pieces 30 may be added in areas of weak support. However, when a single connecting post 310 is not adhered to the transparent glass at its end opposite to the connection piece 30, the configuration with only one connecting post 310 is prone to rotation. Therefore, the number of the connecting posts 310 on the connection piece 30 may be preferably two or more. The greater the number of connecting posts 310 is, the stronger the support strength of the connection piece 30 is. However, as the number of connecting posts 310 increases, even though the connecting posts 310 have anti-refraction structures on their circumferential surfaces, a small amount of light may be still refracted into the connecting posts 310, so that the local display performance of the LED transparent display in the area of the connection piece 30 may be degraded. Therefore, the connecting posts 310 should not be too many, and there should be at least one first through-hole 110 between adjacent connecting posts 310 to reduce the impact of light refraction within the connecting posts 310 on the display performance.

The specific number of connection pieces 30 is generally determined by the area of the PCB board 10, the dimensions of individual connection piece 30, and the weight of the transparent glass. Typically, the combined load-bearing capacity of all the connection pieces 30 may be set to be at least eight times the weight of the LED transparent display.

It should be noted that the above embodiments are merely illustrative of the technical solutions of the present disclosure and are not intended to limit them. Although detailed description has been made on the present disclosure with reference to the aforementioned embodiments, those skilled in the art should understand that modifications can still be made to the technical solutions described in the above embodiments, or equivalent replacements can be made for some of the technical features. Such modifications or replacements do not depart from the spirit and scope of the technical solutions of the embodiments of the present disclosure.

## Claims

1. An LED transparent display, comprising a PCB board, a plurality of LED beads arranged in an array on the PCB board, which is provided with a plurality of first through-holes, the plurality of LED beads are distributed around the plurality of first through-holes, wherein the LED transparent display further comprises:
a plurality of connection pieces, provided on one side of the PCB board opposite to the plurality of LED beads, and each connection piece has a plurality of connecting posts on a side toward the PCB board, the plurality of connecting posts pass through the plurality of first through-holes and are provided with adhesive applied at ends thereof.

2. The LED transparent display according claim 1, wherein the connection pieces are provided with second through-holes corresponding to the plurality of first through-holes.

3. The LED transparent display according claim 1, wherein a height of the connecting posts from the PCB board is not less than a height of the LED beads from the PCB board.

4. The LED transparent display according claim 1, wherein the connecting posts and the connection pieces are integrally formed.

5. The LED transparent display according claim 1, wherein the LED transparent display further comprises:
a reinforcement plate, provided between the PCB board and the connection pieces, the ends of the plurality of connecting posts pass through the reinforcement plate.

6. The LED transparent display according claim 5, wherein the reinforcement plate is provided with third through-holes corresponding to the plurality of first through-holes thereon, and the ends of the plurality of connecting posts sequentially pass through the third through-holes and the first through-holes.

7. The LED transparent display according claim 5, wherein the reinforcement plate is made of carbon fiber.

8. The LED transparent display according any of claims 1-7, wherein the plurality of connecting posts on one connection piece are distributed on both sides of a joint between two PCB boards.

9. The LED transparent display according any of claims 1-7, wherein four connection pieces are provided at four corners on a side of the PCB board opposite to the plurality of LED beads.

10. The LED transparent display according any of claims 1-7, wherein the plurality of connection pieces are provided on a side of the PCB board opposite to the LED beads with regular spacing.

11. The LED transparent display according claim 2, wherein a radius of the second through-hole is greater than or equal to a radius of the first through-hole.

12. The LED transparent display according any of claims 1-7, wherein a diameter of the connecting post is smaller than a diameter of the first through-hole.

13. The LED transparent display according claim 12, wherein a difference between a radius of the first through-hole and a radius of the connecting post is greater than or equal to 0.2 mm and smaller than or equal to 0.3 mm.

14. The LED transparent display according any of claims 1-7, wherein a guiding surface is provided at circumference of the end of the connecting post opposite to the PCB board.

15. The LED transparent display according to any of claims 1-7, wherein the connection piece is provided with at least one connecting post thereon;
at least one first through-hole is provided between two adjacent connecting posts.

16. The LED transparent display according any of claims 1-7, wherein at least the connecting posts and portions of the connection pieces aligned with the connecting posts are made of transparent material.

17. The LED transparent display according claim 12, wherein side surfaces of the connecting posts are frosted.

18. The LED transparent display according any of claims 1-7, wherein a combined support strength of the plurality of connection pieces is at least eight times a weight of the LED transparent display.
